# EUROPÄISCHE PATENTSCHRIFT

(11) **EP 4 096 034 B1**
(45) Veröffentlichungstag und Bekanntmachung des Hinweises auf die Patenterteilung: **07.02.2024**
(21) Anmeldenummer: 22174665.4
(22) Anmeldetag: 20.05.2022
(51) Int. Cl.: H01R 13/66

(54) **STECKVERBINDER FÜR EIN ELEKTRONISCHES STEUERGERÄT UND STEUERGERÄT**
CONTROL DEVICE AND CONNECTOR FOR ELECTRONIC CONTROL DEVICE
CONNECTEUR ENFICHABLE POUR UN APPAREIL ÉLECTRONIQUE DE COMMANDE ET APPAREIL DE COMMANDE

(30) Priorität: 25.05.2021 DE 102021205307
(43) Veröffentlichungstag der Anmeldung: 30.11.2022
(73) Patentinhaber: Robert Bosch GmbH, 70442 Stuttgart (DE)
(72) Erfinder: El Ouardi, Abdessamad, 75428 Illingen (DE); Pham, Thi Hong Chuyen, 71229 Leonberg (DE); Kroeckel, Markus, 71701 Schwieberdingen (DE); Lamdiziz, Mohamed, 71672 Marbach A. N. (DE)

(56) Entgegenhaltungen:
- EP-A1- 3 457 824
- WO-A1-2018/163729
- CN-A- 109 327 976
- KR-A- 20200 069 501
- US-A1- 2009 316 372

## Beschreibung

### Technisches Gebiet

Die Erfindung betrifft einen Steckverbinder für ein elektronisches Steuergerät, wobei der Steckverbinder dazu ausgebildet ist, eine drahtlose Datenkommunikation zu ermöglichen. Ferner betrifft die Erfindung ein Steuergerät mit einem erfindungsgemäßen Steckverbinder.

### Stand der Technik

Aus der DE 10 2005 022 281 B4 ist ein Steckverbinder für ein elektronisches Steuergerät mit den Merkmalen des Oberbegriffs des Anspruchs 1 bekannt. Der bekannte Steckverbinder weist einen Anschlusskörper auf, der im Bereich eines kragenförmigen Verbindungsabschnitts eine Vielzahl von ersten Anschlusssteckerpins umgibt. An der Oberseite des Anschlusskörpers sind die Elemente einer drahtlosen Kommunikationseinrichtung angeordnet, die von dem Material des Anschlusssteckers umspritzt sind. Die Elemente umfassen zwei Antennenelemente und einen mit den Antennenelementen verbundenen Sende-/Empfangs-IC als Antennenelektronik, wobei der Sender-/Empfangs-IC über zusätzliche Drahtverbindungen mit Schaltkreiskomponenten auf einem ersten Schaltungsträger in Form einer Leiterplatte des elektronischen Steuergeräts kontaktiert ist.

Die Montage bzw. das Einlegen derartiger, separater Elemente der Kommunikationseinrichtung in ein Spritzgusswerkzeug zum Herstellen des Anschlusssteckers ist relativ aufwendig. Darüber hinaus besteht die Gefahr, dass aufgrund des Spritzdrucks beim Einspritzen des (verflüssigten) Kunststoffs in das Spritzgusswerkzeug die Position der Antennenelemente bzw. des ICs verändert wird oder die Verbindungen zwischen den Elementen mechanisch stark belastet werden. Aus EP3457824, KR20200069501 oder CN109327976 sind weitere Steckverbinder für ein elektronisches Gerät bekannt.

### Offenbarung der Erfindung

Der erfindungsgemäße Steckverbinder für ein elektronisches Steuergerät mit den Merkmalen des Anspruchs 1 hat den Vorteil, dass sich dessen Bauteile zur Ausbildung der drahtlosen Kommunikationseinrichtung besonders einfach bzw. positionsgenau bei der Fertigung des Steckverbinders in ein entsprechendes Spritzgusswerkzeug einlegen lassen und die Position der Bauelemente mit hoher Präzision reproduzierbar ist.

Der Erfindung liegt die Idee zugrunde, das wenigstens eine Antennenelement zusammen mit der Antennenelektronik in Form einer gemeinsamen Baugruppe auszubilden, wobei die Baugruppe die einen (zweiten) Schaltungsträger umfasst, auf dem die genannten Bauelemente angeordnet sind. Somit genügt es, lediglich den (zweiten) Schaltungsträger in das Spritzgusswerkzeug zur Fertigung des Anschlusskörpers einzulegen, wobei die Position des wenigstens einen Antennenelements und der Antennenelektronik durch die Position des (zweiten) Schaltungsträgers definiert ist. Da die Elemente darüber hinaus üblicherweise starr auf dem (zweiten) Schaltungsträger moniert sind, ist die Baugruppe beim Umspritzen mit dem Kunststoff des Anschlusskörpers mechanisch relativ robust bzw. stark belastbar. Insbesondere lässt sich ein derartiger (zweiter) Schaltungsträger, der üblicherweise plattenförmig ausgebildet ist, auch besonders einfach und positionsgenau in dem Spritzgusswerkzeug positionieren. Vorteilhafte Weiterbildungen des erfindungsgemäßen Steckverbinders für ein elektronisches Steuergerät sind in den Unteransprüchen aufgeführt.

Eine bevorzugte konstruktive Ausgestaltung des zweiten Schaltungsträgers sieht vor, dass im Bereich des zweiten Schaltungsträgers zweite Anschlusssteckerpins angeordnet sind, die mit dem ersten Schaltungsträger verbindbar sind. Insbesondere ist ein derartiger zweiter Anschlusssteckerpin in seiner Bauart und ggf. seinen geometrischen Grundabmessungen identisch zu den ersten Anschlusssteckerpins, die beispielsweise der Signalübertragung dienen, ausgebildet. Dies ermöglicht es, im Verlauf ein und desselben Montage- bzw.

Fügevorgangs den Steckverbinder mit den ersten und den zweiten Anschlusssteckerpins mit dem ersten Schaltungsträger (der üblicherweise in Form einer Leiterplatte ausgebildet ist) zu fügen, beispielsweise dadurch, dass die ersten und zweiten Anschlusssteckerpins als Einpresskontakte ausgebildet sind, die in entsprechende Öffnungen des ersten Schaltungsträgers eingedrückt und gegebenenfalls zusätzlich durch Lötverbindungen mit dem ersten Schaltungsträger verbunden werden.

Ganz besonders bevorzugt ist darüber hinaus eine Ausbildung des Steckverbinders, bei der wenigstens ein von dem zweiten Schaltungsträger als separates Bauteil ausgebildetes Abschirmelement zur Abschirmung elektromagnetischer Strahlung bei einem als Sendeantenne wirkenden Antennenelement vorgesehen ist, wobei das wenigstens eine Abschirmelement insbesondere in Form einer metallischen oder metallisierten Abschirmplatte ausgebildet ist. Ein derartiges Abschirmelement ist dabei typischerweise zwischen dem entsprechenden Antennenelement und den (ersten) Anschlusssteckerpins im Bereich des kragenförmigen Verbindungsabschnitts des Anschlusskörpers angeordnet und schirmt die (ersten) Anschlusssteckerpins vor der Einkopplung elektromagnetischer Strahlung, die die Signale auf den ersten Anschlusssteckerpins verfälschen könnten, ab.

In bevorzugter Weiterbildung eines derartigen Abschirmelements ist es vorgesehen, dass das wenigstens eine Abschirmelement mit dem zweiten Schaltungsträger verbunden und über einen mit elektrischer Masse verbindbaren zweiten Anschlusssteckerpin mit dem ersten Schaltungsträger kontaktierbar ist.

Anstelle oder zusätzlich zu einem derartigen Abschirmelement ist es auch denkbar, eine Abschirmung der ersten Anschlusssteckerpins vor der Einkopplung elektromagnetischer Strahlung bei gleichzeitig guten Antenneneigenschaften dadurch zu bewirken, dass mehrere Antennenelemente mit unterschiedlichen Abstrahlrichtungen und mit einer phasenverschobenen Anregung vorgesehen sind, derart, dass die Abstrahlrichtungen der Antennenelemente von den ersten Anschlusspins weggerichtet angeordnet sind.

Ganz besonders bevorzugt ist es darüber hinaus, wenn die den zweiten Schaltungsträger aufweisende Baugruppe von dem Material des Anschlusskörpers zumindest bereichsweise umspritzt ist. Eine derartige Anordnung bzw. Ausbildung des Steckverbinders schafft eine mediendichte Anordnung der drahtlosen Kommunikationselemente und darüber hinaus auch einen mechanischen Schutz vor äußeren Einflüssen.

Alternativ ist es jedoch auch denkbar, dass die Baugruppe bzw. der zweite Schaltungsträger durch einen von der Fertigung des Anschlusskörpers separaten Montageprozess, insbesondere mittels einer Klebeverbindung oder einer mechanischen Verbindung, mit dem Anschlusskörper verbunden ist. Eine derartige Verbindung ermöglicht es insbesondere, vorgefertigte Steckverbinder bzw. Anschlusskörper zu verwenden bzw. auf besonders einfache Art und Weise ein Baukastensystem zu generieren, das mit ein und demselben Anschlusskörpern auskommt.

Eine weitere Ausgestaltung der Erfindung, die je nach Anwendungsfall besonders gute Sende-/ und/oder Empfangseigenschaften der Antennenelemente ermöglicht, sieht vor, dass die Baugruppe als ein von dem Anschlusskörper separates, insbesondere quaderförmiges Spritzgussteil ausgebildet ist, und dass mehrere Antennenelemente vorgesehen sind, die zur Ausbildung unterschiedlicher Empfangs- und/oder Abstrahlrichtungen an unterschiedlich orientierten Flächen des Spritzgussteils angeordnet ist.

Auch kann es zu Optimierung der Sende- und Empfangseigenschaften vorgesehen sein, dass mehrere Baugruppen an dem Anschlusskörper vorgesehen sind.

Zuletzt umfasst die Erfindung auch ein Steuergerät mit einem soweit beschriebenen erfindungsgemäßen Steckverbinder.

Weitere Vorteile, Merkmale und Einzelheiten der Erfindung ergeben sich aus der nachfolgenden Beschreibung bevorzugter Ausführungsformen der Erfindung sowie anhand der Zeichnungen.

Kurze Beschreibung der Zeichnungen
- Fig. 1: zeigt in einer perspektivischen Darstellung ein elektronisches Steuergerät mit einem zur Kontaktierung mit einem Gegenstecker dienenden Steckverbinder,
- Fig. 2: eine perspektivische Darstellung eines Schaltungsträgers des Steuergeräts mit Teilen des Steckverbinders und einem Abschirmelement,
- Fig. 3: eine weitere perspektivische Darstellung einer mit einem Schaltungsträger des Steuergeräts verbundenen Baugruppe,
- Fig. 4: eine Darstellung einer alternativen Anordnung von Antennenelementen zur Abschirmung elektromagnetischer Strahlung und
- Fig. 5: eine perspektivische Darstellung eines quaderförmigen Bauelements zur Aufnahme mehrerer Antennenelemente.

### Ausführungsformen der Erfindung

Gleiche Elemente bzw. Elemente mit gleicher Funktion sind in den Figuren mit den gleichen Bezugsziffern versehen.

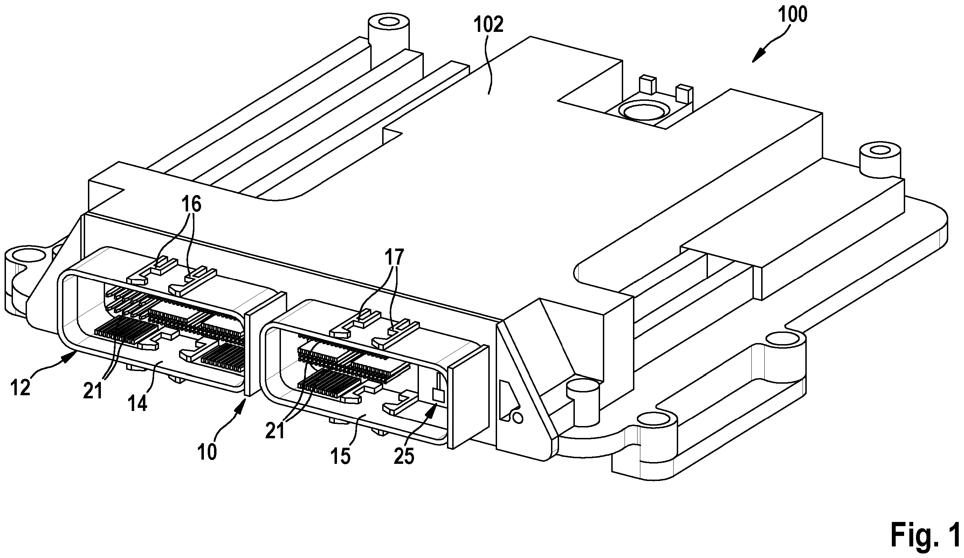

In der Fig. 1 ist ein elektronisches Steuergerät 100 dargestellt, wie es beispielsweise für Automotive-Bereich im Rahmen der Elektromobilität o.ä. Anwendungen verwendet werden kann. Das Steuergerät 100 weist ein beispielsweise aus Aluminium bestehendes Gehäuse 102 auf, aus dem seitlich ein Steckverbinder 10 herausragt. Der Steckverbinder 10 dient der Kontaktierung mit einem nicht dargestellten Gegenstecker, insbesondere einem Gegenstecker eines Kabelbaums eines Fahrzeugs.

Der Steckverbinder 10 weist einen aus Kunststoff bestehenden und im Spritzgussverfahren hergestellten Anschlusskörper 12 auf, der beispielhaft zwei kragenförmig umlaufende, in etwa rechteckförmige Verbindungsabschnitte 14, 15 aufweist, die von jeweils einem entsprechenden Gegenstecker des Kabelbaums des Fahrzeugs umgriffen und mechanisch mit diesen arretiert werden können, was durch an den Oberseiten der Verbindungsabschnitte 14, 15 monolithisch angeformten Verriegelungselemente 16, 17 verdeutlicht sein soll. Der Anschlusskörper 12 bildet auf der dem Gehäuse 102 zugewandten Seite eine Anschlussplatte 20 aus, die eine Öffnung des Gehäuses 102 verschließt bzw. überdeckt, und mittels derer der Anschlusskörper 12 beispielsweise über Schraubverbindungen oder ähnliche, aus dem Stand der Technik bekannte Technologien mit dem Gehäuse 102 insbesondere mediendicht verbunden ist.

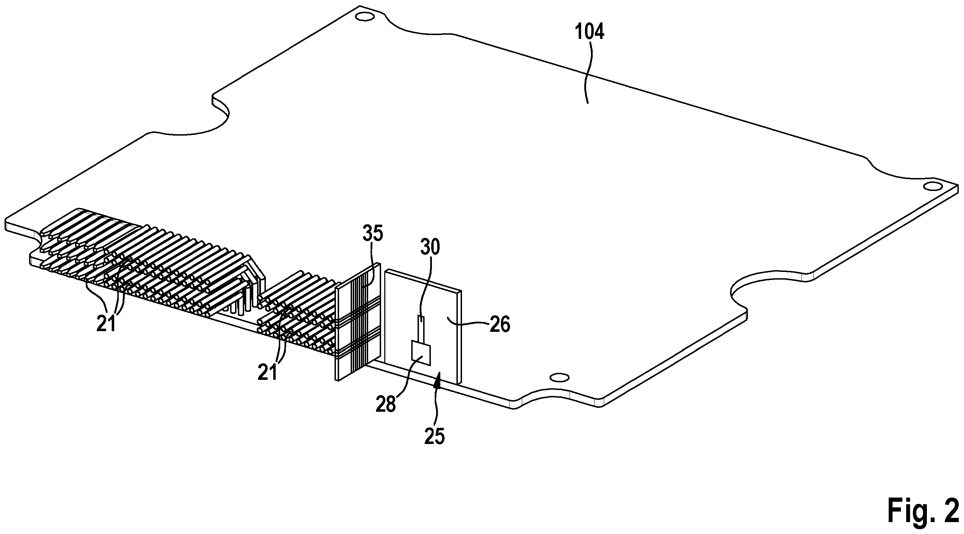

Jeder Verbindungsabschnitt 14, 15 umgibt erste Anschlusssteckerpins 21, die mit einem innerhalb des Steuergeräts 100 angeordneten ersten Schaltungsträger 104 (Fig. 2) kontaktiert sind. Der erste Schaltungsträger 104, der üblicherweise in Form einer Leiterplatte ausgebildet ist, weist hierzu beispielsweise den ersten Anschlusssteckerpins 21 angepasste Öffnungen auf, wobei die ersten Anschlusssteckerpins 21 auf der dem ersten Schaltungsträger 104 zugewandten Seite beispielhaft als Einpresspins ausgebildet sind.

Im Bereich des Verbindungsabschnitts 15, insbesondere in der Ebene der Anschlussplatte 20 sind nicht nur erste Anschlusssteckerpins 21 angeordnet, sondern darüber hinaus eine Baugruppe 25, die der drahtlosen Kommunikation bzw. dem drahtlosen Datenaustausch zwischen dem Steuergerät 100 und externen Einrichtungen, wie Sensoren, anderen Steuergerät o.ä. Einheiten dient.

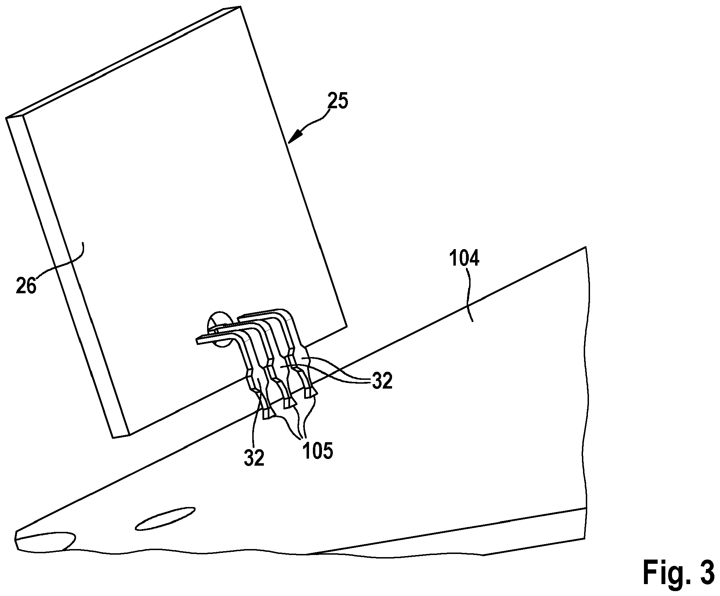

Insbesondere umfasst die Baugruppe 25 entsprechend der Darstellung der Fig. 2 und der Fig. 3 ein Trägerelement in Form eines zweiten Schaltungsträgers 26 bzw. einer (kleinen) Leiterplatte, eines Substrats o.ä. Element, auf dem eine Antennenelektronik 28, zum Beispiel in Form eines lös, angeordnet ist. Weiterhin ist die Antennenelektronik 28 mit wenigstens einem Antennenelement 30 verbunden, das wiederum auf dem zweiten Schaltungsträger 26 positioniert bzw. fixiert ist.

Die Baugruppe 25, die eine relativ geringe Bauhöhe aufweist, ist von dem Material des Anschlusskörpers 12, insbesondere von dem Material der Anschlussplatte 20, zumindest bereichsweise umgeben bzw. umspritzt, um eine mediendichte Anordnung der Baugruppe 25 in dem Anschlusskörper 12 zu ermöglichen. Weiterhin umfasst die Baugruppe 25 zweite Anschlusssteckerpins 32, die auf der dem Innenraum des Steuergeräts 100 zugewandten Seite angeordnet sind und entsprechend der Darstellung der Fig. 3 ebenfalls mit dem Schaltungsträger 104 im Bereich von drei Durchgangsöffnungen 105 kontaktierbar sind. Mittels der zweiten Anschlusssteckerpins 32 ist die Antennenelektronik 28 der Baugruppe 25 kontaktierbar bzw. es wird auch eine Stromversorgung der Baugruppe 25 sichergestellt. Auch kann ein zweiter Anschlusssteckerpin 32 mit einer elektrischen Masse des Steuergeräts 100 über den ersten Schaltungsträger 104 verbunden sein. Dies ist insbesondere dann der Fall bzw. vorteilhaft, wenn zusätzlich ein Abschirmelement 35 vorgesehen ist, das in der Fig. 2 erkennbar ist.

Das plattenförmige, aus Metall oder aus einem metallisierten Kunststoff bestehende Abschirmelement 35 ist mit der Baugruppe 25 vorzugsweise verbunden und wie oben erläutert über einen zweiten Anschlusssteckerpin 32 mit elektrischer Masse kontaktiert. Das senkrecht von der Ebene des zweiten Schaltungsträgers 26 abstehende Abschirmelement 35 bewirkt, für den Fall, dass das wenigstens eine Antennenelement 28 als Sendeantenne arbeitet, dass seitlich zu dem Antennenelement 28 angeordnete erste Anschlusssteckerpins 21 abgeschirmt werden, um eine Einkopplung elektromagnetischer Strahlung von dem Antennenelement 28 zu verhindern.

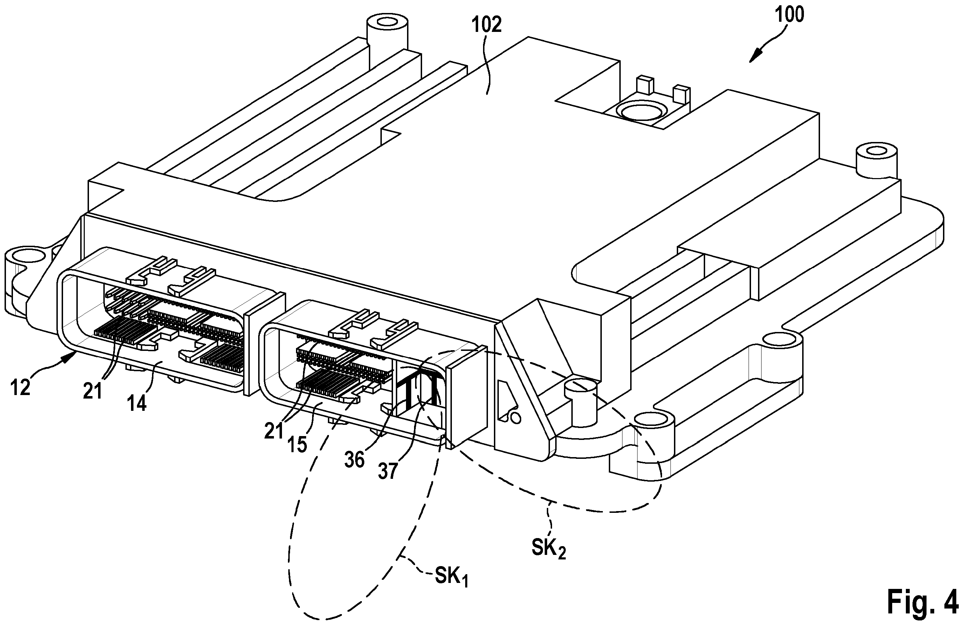

Die Fig. 4 zeigt eine alternative Ausgestaltung ohne ein (separates) Abschirmelement 35, das jedoch optional ebenfalls vorgesehen sein kann, um die Abschirmwirkung zu optimieren. Hierzu sind beispielhaft zwei, als Sendeantenne oder Empfangsantenne arbeitende Antennenelemente 36, 37 vorgesehen, die derart angeordnet bzw. ausgerichtet sind, dass bei einem Sendebetrieb deren Sendekeulen SK₁ und SK₂ von den ersten Anschlusssteckerpins 21 weg ausgerichtet sind bzw. abstrahlen. Weiterhin werden die beiden Antennenelemente 36, 37 mit einer phasenverschobenen Anregung angesteuert.

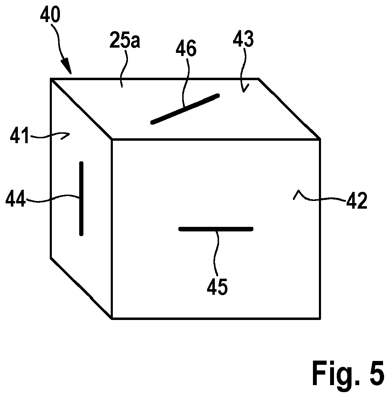

In der Fig. 5 ist ein Spritzgussteil 40 gezeigt, das ebenfalls eine Baugruppe 25a ausbildet. Das Spritzgussteil 40, das beispielhaft quaderförmig ausgebildet ist, weist drei senkrecht zueinander angeordnete Seitenflächen 41 bis 43 auf, in deren Bereich beispielhaft drei Antennenelemente 44 bis 46 angeordnet sind. Durch die Anordnung der Antennenelemente 44 bis 46 lassen sich beispielsweise unterschiedliche Abstrahl- bzw. Empfangsrichtungen der Antennenelemente 44 bis 46 generieren und somit ein optimaler Empfang bzw. optimale Sendeeigenschaften. Das Spritzgussteil 40 bzw. die Baugruppe 25a kann beispielsweise durch einen separaten Montagevorgang, beispielsweise durch eine Klebeverbindung oder durch eine Schraubverbindung, mit dem Anschlusskörper 12 des Steckerbinders 10 verbunden werden (nicht dargestellt), beispielsweise mit der Anschlussplatte 20 auf der dem Gehäuse 102 des Steuergeräts 100 abgewandten Seite.

Der soweit beschriebene Steckverbinder 10 kann in vielfältiger Art und Weise abgewandelt bzw. modifiziert werden, ohne vom Erfindungsgedanken abzuweichen. So ist es beispielsweise denkbar, die Baugruppe 25 im Bereich des Verbindungsabschnitts 15 anzuordnen, derart, dass diese vom Material des Verbindungsabschnitts 15 zumindest bereichsweise umspritzt ist.

## Patentansprüche

1. Steckverbinder (10) für ein elektronisches Steuergerät (100), mit einem als Spritzgussteil ausgebildeten und aus Kunststoff bestehenden Anschlusskörper (12) zur Kontaktierung eines mit dem Steuergerät (100) kontaktierbaren Gegensteckers, wobei der Anschlusskörper (12) einen kragenförmigen Verbindungsabschnitt (14, 15) für den Gegenstecker aufweist, wobei der Verbindungsabschnitt (14, 15) erste Anschlusssteckerpins (21) umgibt, die mit einem eine elektronische Schaltung ausbildenden ersten Schaltungsträger (104) des Steuergeräts (100) kontaktierbar sind, und mit wenigstens einem Antennenelement (30; 35, 36; 44 bis 46), das mit einer Antennenelektronik (28) zusammenwirkt und mit der elektronischen Schaltung des ersten Schaltungsträgers (104) verbindbar ist,
**dadurch gekennzeichnet,**
**dass** zur Ausbildung einer gemeinsamen Baugruppe (25; 25a) das wenigstens eine Antennenelement (30; 35, 36; 44 bis 46) zusammen mit der Antennenelektronik (28) auf einem zweiten Schaltungsträger (26) angeordnet sind.

2. Steckverbinder nach Anspruch 1,
**dadurch gekennzeichnet,**
**dass** im Bereich des zweiten Schaltungsträgers (26) zweite Anschlusssteckerpins (32) angeordnet sind, die mit dem ersten Schaltungsträger (104) verbindbar sind.

3. Steckverbinder nach Anspruch 1 oder 2,
**dadurch gekennzeichnet,**
**dass** wenigstens ein von dem zweiten Schaltungsträger (26) als separates Bauteil ausgebildetes Abschirmelement (35) zur Abschirmung elektromagnetischer Strahlung bei einem als Sendeantenne wirkenden Antennenelement (30) vorgesehen ist, wobei das wenigstens eine Abschirmelement (35) insbesondere in Form einer metallischen oder metallisierten Abschirmplatte ausgebildet ist.

4. Steckverbinder nach Anspruch 3,
**dadurch gekennzeichnet,**
**dass** das wenigstens eine Abschirmelement (35) mit dem zweiten Schaltungsträger (26) verbunden und über einen mit elektrischer Masse verbindbaren zweiten Anschlusssteckerpin (32) mit dem ersten Schaltungsträger (104) kontaktierbar ist.

5. Steckverbinder nach Anspruch 1 oder 2,
**dadurch gekennzeichnet,**
**dass** mehrere Antennenelemente (36, 37) mit unterschiedlichen Abstrahlrichtungen und mit einer phasenverschobenen Anregung vorgesehen sind, derart, dass die Abstrahlrichtungen von den ersten Anschlusspins (21) weggerichtet angeordnet sind.

6. Steckverbinder nach einem der Ansprüche 1 bis 5,
**dadurch gekennzeichnet,**
**dass** der zweite Schaltungsträger (26) von dem Material des Anschlusskörpers (12) zumindest bereichsweise umspritzt ist.

7. Steckverbinder nach einem der Ansprüche 1 bis 5,
**dadurch gekennzeichnet,**
**dass** die Baugruppe (25) durch einen von der Fertigung des Anschlusskörpers (12) separaten Montageprozess, insbesondere mittels einer Klebeverbindung oder einer mechanischen Verbindung, mit dem Anschlusskörper (12) verbunden ist.

8. Steckverbinder nach einem der Ansprüche 1 bis 4,
**dadurch gekennzeichnet,**
**dass** die Baugruppe (25a) als ein von dem Anschlusskörper (12) separates, insbesondere quaderförmiges Spritzgussteil (40) ausgebildet ist, und dass mehrere Antennenelemente (44 bis 46) vorgesehen sind, die zur Ausbildung unterschiedlicher Empfangs- und/oder Abstrahlrichtungen im Bereich unterschiedlich orientierter Flächen (41 bis 43) des Spritzgussteils (40) angeordnet sind.

9. Steckverbinder nach einem der Ansprüche 1 bis 8,
**dadurch gekennzeichnet,**
**dass** mehrere Baugruppen (25; 25a) an dem Anschlusskörper (12) vorgesehen sind.

10. Steuergerät (100), mit einem Steckverbinder (10), der nach einem der Ansprüche 1 bis 9 ausgebildet ist.

## Claims

1. Plug-in connector (10) for an electronic control device (100), having a connection body (12), which is designed as an injection-moulded part and consists of plastic, for making contact with a mating plug which can be contact-connected to the control device (100), wherein the connection body (12) has a collar-like connecting section (14, 15) for the mating plug, wherein the connecting section (14, 15) surrounds first connection plug pins (21) which can be contact-connected to a first circuit carrier (104), which forms an electronic circuit, of the control device (100), and having at least one antenna element (30; 35, 36; 44 to 46), which interacts with an antenna electronics system (28) and can be connected to the electronic circuit of the first circuit carrier (104),
**characterized**
**in that**, in order to form a common assembly (25; 25a) , the at least one antenna element (30; 35, 36; 44 to 46) together with the antenna electronics system (28) are arranged on a second circuit carrier (26).

2. Plug-in connector according to Claim 1,
**characterized**
**in that** second connection plug pins (32), which can be connected to the first circuit carrier (104), are arranged in the region of the second circuit carrier (26) .

3. Plug-in connector according to Claim 1 or 2,
**characterized**
**in that** at least one shielding element (35), which is formed as a separate component from the second circuit carrier (26), is provided for shielding electromagnetic radiation for an antenna element (30) acting as a transmitting antenna, wherein the at least one shielding element (35) is designed, in particular, in the form of a metal or metallized shielding plate.

4. Plug-in connector according to Claim 3,
**characterized**
**in that** the at least one shielding element (35) is connected to the second circuit carrier (26) and can be contact-connected to the first circuit carrier (104) by means of a second connection plug pin (32) which can be connected to electrical earth.

5. Plug-in connector according to Claim 1 or 2,
**characterized**
**in that** a plurality of antenna elements (36, 37) are provided with different emission directions and with phase-shifted excitation in such a way that the emission directions are arranged in a manner directed away from the first connection pins (21).

6. Plug-in connector according to any of Claims 1 to 5,
**characterized**
**in that** the second circuit carrier (26) is overmoulded at least in regions by the material of the connection body (12).

7. Plug-in connector according to any of Claims 1 to 5,
**characterized**
**in that** the assembly (25) is connected to the connection body (12) by an assembly process which is separate from the manufacture of the connection body (12), in particular by means of an adhesive bond or a mechanical connection.

8. Plug-in connector according to any of Claims 1 to 4,
**characterized**
**in that** the assembly (25a) is designed as an, in particular cuboidal, injection-moulded part (40) which is separate from the connection body (12), and in that a plurality of antenna elements (44 to 46) are provided, which are arranged in the region of differently oriented surfaces (41 to 43) of the injection-moulded part (40) for forming different receiving and/or emission directions.

9. Plug-in connector according to any of Claims 1 to 8,
**characterized**
**in that** a plurality of assemblies (25; 25a) are provided on the connection body (12).

10. Control device (100), having a plug-in connector (10), which is designed according to any of Claims 1 to 9.

## Revendications

1. Connecteur enfichable (10) pour un contrôleur (100) électronique, comprenant un corps de raccordement (12), réalisé sous la forme d'une pièce moulée par injection et constitué de matière plastique, destiné à la mise en contact avec une fiche homologue pouvant être mise en contact avec le contrôleur (100), le corps de raccordement (12) possédant une portion de liaison (14, 15) en forme de collerette pour la fiche homologue, la portion de liaison (14, 15) entourant des premières broches de fiche de raccordement (21), lesquelles peuvent être mises en contact avec un premier support de circuit (104) du contrôleur (100) formant un circuit électronique, et comprenant au moins un élément d'antenne (30 ; 35, 36 ; 44 à 46), qui coopère avec une électronique d'antenne (28) et peut être relié au circuit électronique du premier support de circuit (104),
**caractérisé en ce**
**qu'**en vue de former un module commun (25 ; 25a), l'au moins un élément d'antenne (30 ; 35, 36 ; 44 à 46) est disposé conjointement avec l'électronique d'antenne (28) sur un deuxième support de circuit (26).

2. Connecteur enfichable selon la revendication 1, **caractérisé en ce**
**que** dans la zone du deuxième support de circuit (26) sont disposées des deuxièmes broches de fiche de raccordement (32), lesquelles peuvent être reliées au premier support de circuit (104).

3. Connecteur enfichable selon la revendication 1 ou 2,
**caractérisé en ce**
**qu'**au moins un élément de blindage (35) est présent, réalisé sous la forme d'un élément structural séparé du deuxième support de circuit (26) et destiné à réaliser un blindage contre un rayonnement électromagnétique dans le cas d'un élément d'antenne (30) agissant comme antenne d'émission, l'au moins un élément de blindage (35) étant notamment réalisé sous forme d'une plaque de blindage métallique ou métallisée.

4. Connecteur enfichable selon la revendication 3, **caractérisé en ce**
**que** l'au moins un élément de blindage (35) est relié au deuxième support de circuit (26) et peut être mis en contact avec le premier support de circuit (104) par le biais d'une deuxième broche de fiche de raccordement (32) qui peut être reliée à la masse.

5. Connecteur enfichable selon la revendication 1 ou 2,
**caractérisé en ce**
**que** plusieurs éléments d'antenne (36, 37) ayant des directions de rayonnement différentes et comportant une excitation déphasée sont présents, de telle sorte que les directions de rayonnement sont disposées orientées à l'écart des premières broches de raccordement (21).

6. Connecteur enfichable selon l'une des revendications 1 à 5,
**caractérisé en ce**
**que** le deuxième support de circuit (26) est surmoulé au moins dans certaines zones par le matériau du corps de raccordement (12).

7. Connecteur enfichable selon l'une des revendications 1 à 5,
**caractérisé en ce**
**que** le module (25) est relié au corps de raccordement (12) par un processus de montage séparé de la fabrication du corps de raccordement (12), notamment au moyen d'une liaison par collage ou d'une liaison mécanique.

8. Connecteur enfichable selon l'une des revendications 1 à 4,
**caractérisé en ce**
**que** le module (25a) est réalisé sous la forme d'une pièce moulée par injection (40) séparée du corps de raccordement, notamment parallélépipédique, et **en ce que** plusieurs éléments d'antenne (44 à 46) sont présents, lesquels sont disposés en vue de former des directions de réception et/ou de rayonnement différentes dans la zone de surfaces (41 à 43) orientées différemment de la pièce moulée par injection (40).

9. Connecteur enfichable selon l'une des revendications 1 à 8,
**caractérisé en ce**
**que** plusieurs modules (25 ; 25a) sont présents sur le corps de raccordement (12).

10. Contrôleur (100), comprenant un connecteur enfichable (10) qui est configuré selon l'une des revendications 1 à 9.
